Europäisches Patentamt

European Patent Office

Office européen des brevets

(11) Veröffentlichungsnummer: **0 260 630**
**A2**

(12) # EUROPÄISCHE PATENTANMELDUNG

(21) Anmeldenummer: 87113372.4

(22) Anmeldetag: 12.09.87

(51) Int. Cl.⁴: **C22C 5/02** , H01J 37/34

(30) Priorität: 19.09.86 DE 3631830

(43) Veröffentlichungstag der Anmeldung:
23.03.88 Patentblatt 88/12

(84) Benannte Vertragsstaaten:
AT BE CH DE ES FR GB GR IT LI LU NL SE

(71) Anmelder: Leybold-Heraeus GmbH
Bonner Strasse 504 Postfach 51 07 60
D-5000 Köln 51(DE)

Anmelder: DEMETRON Gesellschaft für
Elektronik-Werkstoffe m.b.H.
Leipziger Strasse 10
D-6450 Hanau 1(DE)

(72) Erfinder: Hofmann, Dieter, Dipl.-Ing.
Kinzigheimer Weg 7
D-6454 Bruchköbel(DE)
Erfinder: Münz, Wolf-Dieter, Dr.Phys.
Im Schwalbengrund 25
D-6463 Freigericht-1(DE)
Erfinder: Siewert, G.A. Horst, Dr.
Geiselbacher Strasse 19
D-6463 Freigericht-4(DE)
Erfinder: Dietrich, Horst
Stettiner Strasse 4
D-6461 Biebergemünd-2(DE)

(74) Vertreter: Zapfe, Hans, Dipl.-Ing.
Seestrasse 2 Postfach 30 04 08
D-6054 Rodgau-3(DE)

(54) Mehrstofflegierung für Targets von Katodenzerstäubungsanlagen und deren Verwendung.

(57) Mehrstofflegierung für und Verwendung von Targets in Katodenzerstäubungsanlagen zum Aufstäuben von Goldschichten mit goldfremden Legierungsanteilen, die aus 0,5 bis 10 Gewichtsprozent Aluminium und im übrigen aus Kupfer bestehen. Der Goldanteil hat einen Wert zwischen 85 und 98 Gewichtsprozent.

EP 0 260 630 A2

## " Mehrstofflegierung für Targets von Katodenzerstäubungsanlagen und deren Verwendung "

Die Erfindung betrifft eine Mehrstofflegierung für Targets von Katodenzerstäubungsanlagen zum Aufstäuben von Goldschichten mit goldfremden Legierungsanteilen, die aus 0,5 bis 10 Gesichtsprozent Aluminium und im übrigen aus Kupfer bestehen.

Eine derartige Mehrstofflegierung ist durch die DE-PS 31 42 541 bekannt. Dabei liegt der Goldanteil zwischen 45 und 65 Gewichtsprozent mit einem Schwerpunkt zwischen 57,5 und 59,5 Gewichtsprozent.

Bei Standard-Goldfarben, die auf einem Goldanteil bis zu 65 Gewichtsprozent beruhen, ist notwendigerweise ein großer Anteil an goldfremden Metallen vorhanden, insbesondere an Kupfer, das als "Rotmacher" dient. Der Einfluß des Kupfers muß infolgedessen wiederum durch Aluminium kompensiert werden, das als "Weißmacher" dient, damit der sich in der CIELAB-Einheit a* ausdrückende Rotanteil nicht zu hoch wird. Folgende CIELAB-Einheiten sind für ansprechende Goldlegierungen typisch:
Glanz / Brillanz ........... $L^* = 85$ bis 90
Rotfärbung ................. $a^* = 0,5$ bis 3
Gelbfärbung ............... $b^* = 26$ bis 30.

Eine Goldoberfläche, deren CIELAB-Einheiten innerhalb der vorstehend genannten Bereiche liegen, wird in Westeuropa als Standard-Goldfarbe angesehen.

Die vorstehend genannten CIELAB-Einheiten werden mittels einer Meßmethode bestimmt, die sich bekanntlich in den letzten Jahren bei den Herstellern von Oberflächenschichten, insbesondere von Dekorationsschichten durchgesetzt hat. Es handelt sich um eine colorimetrische Meßmethode, bei der ein Meßlichtstrahl einer genormten Lichtquelle mit ganz bestimmten spektralen Eigenschaften auf das Meßobjekt gerichtet und der reflektierte Meßlichtanteil im optisch sichtbaren Wellenlängenbereich des Spektrums ausgewertet wird. Durch eine rechnerische Auswertung läßt sich der Grad der Helligkeit ebenso bestimmen, wie beispielsweise die maßgeblich den Goldfarbton bestimmenden Farbanteile von Rot und Gelb. Die Grundlagen der Meßmethode sind beispielsweise bei R.M. German, M.M. Guzowsky und D.C. Wright in "Journal of Metals", März 1980, Seiten 20 ff. sowie von denselben Autoren in "Gold Bulletin", July 1980, Seiten 113 ff., beschrieben.

Wenn man versucht, einen durch die vorstehenden Bereiche definierten Standard-Goldfarbton mit einer der bekannten Targetlegierungen zu erhalten, dann wird durch den Sputterprozeß der Kupferanteil in der Schicht so hoch, daß trotz des dann zur Farbkompensation notwendigen hohen Aluminiumanteils keine ausreichende Korrosionsfestigkeit mehr gegeben ist. Es gelingt infolgedessen nicht, die Standardwerte richtig einzustellen und gleichzeitig die erforderliche Korrosionsbeständigkeit zu erhalten. Insbesondere gelingt es nicht, die sich in einem hohen $L^*$-Wert ausdrückende hohe Brillanz von mindestens $L^* = 85$ zu erhalten.

Die DIN-Norm 8238 gibt Goldlegierungen mit Einheiten 1N bis 4N an und erklärt diese Einheiten als Standardfarben. Bei der Übertragung dieser alten Farbwerte in die neuerdings gebräuchlichen CIELAB-Einheiten zeigt sich, daß die obigen CIELAB-Standardwerte nur mit einem Silberanteil in der Legierung erhalten werden können, der zwischen 1 und 10 Gewichtsprozent liegt. Solche Legierungen erweisen sich jedoch gleichfalls als nicht beständig gegen Korrosion bzw. "Anlaufen".

Der Erfindung liegt daher die Aufgabe zugrunde, eine Mehrstofflegierung der eingangs beschriebenen Art bezüglich ihrer Komponenten so zu quantifizieren, daß die genannten Bereiche für die obigen CIELAB-Standardwerte eingehalten werden, daß das Target gute Zerstäubungseigenschaften im Hinblick auf eine hohe Zerstäubungsrate, eine konstante Schichtzusammensetzung über lange Zerstäubungszeiten und reproduzierbare Schichteigenschaften aufweist und gleichzeitig zu einer guten Korrosionsbeständigkeit führt.

Die Lösung der gestellten Aufgabe erfolgt bei der eingangs angegebenen Mehrstofflegierung erfindungsgemäß dadurch, daß der Goldanteil einen Wert zwischen 85 und 98 Gewichtsprozent, vorzugsweise zwischen 90 und 98 Gewichtsprozent und insbesondere vorzugsweise zwischen 94 und 97 Gewichtsprozent aufweist, wobei in den als vorzugsweise angegebenen Fällen der Aluminiumanteil zwischen 0,5 und 5 Gewichtsprozent liegt.

Durch den merklich höheren Goldanteil ergeben sich vorteilhafte Goldschichten mit Goldtönen, deren CIELAB-Werte innerhalb der oben genannten Bereiche liegen. Die betreffenden Targets zeichnen sich durch sehr gute Zerstäubungseigenschaften bei hoher Zerstäubungsrate aus, und auch die Schichtzusammensetzung bzw. die Reproduzierbarkeit der Schichteigenschaften bleibt über eine lange Zerstäubungsdauer bekannt. Hierbei ist zu beachten, daß das Targetmaterial sich während der Zerstäubung verbraucht und daß nicht von allen Legierungskomponenten die gleiche Zerstäubungsgeschwindigkeit erwartet werden kann, so daß üblicherweise sogar mit einer zunehmenden Entmischung zu rechnen ist. Die Erfahrung hat jedoch gezeigt, daß diese Effekte bei der erfindungsgemäßen Legierungszusammensetzung nicht oder nicht in einem merklichen Umfange auftreten.

Die erfindungsgemäße Mehrstofflegierung hat außerdem den Vorteil, daß mit dem ihr eigenen Aluminiumanteil nicht nur der geforderte Goldton, sondern zusätzlich auch eine gute Korrosionsbeständigkeit und Abriebfestigkeit erzielt werden konnte. Darüberhinaus konnten mittels des gleichen Targets in aufeinanderfolgenden Arbeitszyklen zahlreiche Chargen beschichtet werden, ohne daß hierunter die Reproduzierbarkeit der Zusammensetzung der Schicht gelitten hätte.

Die Verhältnisse können noch dadurch verbessert werden, daß man den Legierungen weitere Legierungskomponenten zusetzt, wobei mindestens eine zusätzliche Legierungskomponente aus der Gruppe der Metalle Co, Ni, Ga, Ti, In, Cd, Sn, Fe und Pd mit einem Anteil zwischen jeweils 0,1 bis 5 Gewichtsprozent vorhanden ist, wobei die Summe aller zusätzlichen Legierungskomponenten den Wert von 6 Gewichtsprozent nicht überschreitet.

Durch die zusätzlichen Legierungskomponenten wird naturgemäß der Kupferanteil weiter zurückgedrängt. Keineswegs wird aber für jede der weiteren Komponenten immer entweder die untere oder die obere Grenze der angegebenen Bereiche gewählt. Die Wahl geeigneter Werte läßt sich innerhalb der angegebenen Bereiche durch Versuche feststellen.

## Beispiele:

Bei der Durchführung der nachstehend näher erläuterten Versuchsbeispiele befand sich eine Katodenanordnung bekannter Art im Innern einer Vakuumkammer, die vor dem Beschichtungsvorgang auf Drücke zwischen $5 \times 10^{-6}$ und $1 \times 10^{-4}$ mbar evakuiert wurde. Der Zerstäubungsvorgang wurde in neutraler Atmosphäre unter laufender Zufuhr von Argon als Zerstäubungsgas bei einem Druck zwischen $1 \times 10^{-3}$ und $2 \times 10^{-2}$ mbar durchgeführt. Die Zerstäubungsparameter Strom, Spannung und Substrattemperatur wurden in üblicher Weise optimiert bzw. geregelt.

Die haftfeste Beschichtung von Substraten erfordert üblicherweise die Aufbringung einer dünnen Zwischenschicht als Haftvermittler. Die Beschichtung mit der Goldlegierung wurde auf Messing-, Edelstahl-und Neusilber-Substraten unter Verwendung der Haftvermittler Chrom, Titan, NiCr, Molybdän und Wolfram durchgeführt, die sich im wesentlichen als gleich wirksam erwiesen.

## Beispiel 1:

Von einem Target mit den Abmessungen 488 x 88 x 6mm³ und der Zusammensetzung:

95 % Au
1,25% Al
3,75% Cu

wurde in reiner Argon-Atmosphäre in einer Katodenzerstäubungsanlage auf ebene Edelstahlsubstrate aufgestäubt. Die Schicht wies bei der Messung mit einer Lichtquelle C die folgenden CIELAB-Einheiten auf:

$L^* = 87$
$a^* = 1,8$
$b^* = 29$.

Die Farbe dieser Beschichtung entsprach einem Goldfarbton, der zwischen den Schweizer Standards NIHS 03-50 für die Farbtöne 2N18 und 3N18 (nach DIN) einzuordnen ist. Die Korrosionsprüfung der Beschichtung mit der Salzsprühnebelprüfung nach DIN 50021 (SS DIN 50021) und mit dem Schwitzwassertest nach DIN 50017 (STW 24 DIN 50017) zeigten eine gute Korrosionsbeständigkeit der Schicht.

## Beispiel 2:

In einer Mehrkammer-Durchlaufanlage wurden an einer spiegelsymmetrischen Doppelkatodenanordnung zwei Targets folgender Zusammensetzung befestigt:

95 % Au
3,65 % Cu
1,35 % Al.

Nach Durchführung eines Ionenätzprozesses wurde in reiner Argon-Atmosphäre eine Schicht von 1 µm Dicke auf Edelstahlplatten aufgebracht. Von dem Ätzprozeß waren diese Platten auf 160 °C aufgeheizt worden. Die mit der Lichtquelle C geme     senen Farbwerte waren:

$L^* = 87$
$a^* = 1,1$
$b^* = 28$.

Die Farbe dieser Schicht entsprach einem Goldfarbton nach DIN 8238 von 2N18. Das Korrosionsverhalten der Beschichtung zeigte jedoch gegenüber den silberhaltigen Goldlegierungen nach DIN eine deutliche Verbesserung der Beständigkeit im Korrosionstest mit Thioacetamid, die für qualitativ hochwertige Goldlegierungsschichten auf Uhrengehäusen und Uhrarmbändern erreicht werden muß.

Sämtliche Prozentangaben sind Gewichtsprozente.

## Ansprüche

1. Mehrstofflegierung für Targets von Katodenzerstäubungsanlagen zum Aufstäuben von Goldschichten mit goldfremden Legierungsanteilen, die aus 0,5 bis 10 Gewichtsprozent Aluminium und im übrigen aus Kupfer bestehen, dadurch gekennzeichnet, daß der Goldanteil einen Wert zwischen 85 und 98 Gewichtsprozent hat.

2. Mehrstofflegierung nach Anspruch 1, dadurch gekennzeichnet, daß der Goldanteil einen Wert zwischen 90 und 98 Gewichtsprozent und der Aluminiumanteil zwischen 0,5 und 5 Gewichtsprozent hat.

3. Mehrstofflegierung nach Anspruch 1, dadurch gekennzeichnet, daß der Goldanteil einen Wert zwischen 94 und 97 Gewichtsprozent und der Aluminiumanteil einen Wert zwischen 0,5 und 5 Gewichtsprozent hat.

4. Mehrstofflegierung nach mindestens einem der Ansprüche 1 bis 3, dadurch gekennzeichnet, daß mindestens eine zusätzliche Legierungskomponente aus der Gruppe der Metalle Co, Ni, Ga, Ti, In, Cd, Sn, Fe und Pd mit einem Anteil zwischen jeweils 0,1 bis 5 Gewichtsprozent vorhanden ist, wobei die Summe aller zusätzlichen Legierungskomponenten den Wert von 6 Gewichtsprozent nicht überschreitet.

5. Verwendung einer Mehrstofflegierung nach mindestens einem der Ansprüche 1 bis 4 als Targetmaterial in Katodenzerstäubungsanlagen zum Herstellen von korrosionsbeständigen dekorativen Oberflächenschichten mit folgenden CIELAB-Einheiten:

$L^* = 85$ bis $90$

$a^* = 0,5$ bis $3$

$b^* = 26$ bis $30$.